Europäisches Patentamt

European Patent Office

Office européen des brevets

(19)

(11) **EP 0 645 888 B1**

(12)

# FASCICULE DE BREVET EUROPEEN

(45) Date de publication et mention
de la délivrance du brevet:
**04.03.1998 Bulletin 1998/10**

(51) Int Cl.⁶: **H03K 5/13**

(21) Numéro de dépôt: **94410080.9**

(22) Date de dépôt: **21.09.1994**

(54) **Ligne à retard numérique**

Digitale Verzögerungsleitung

Digital delay line

(84) Etats contractants désignés:
**DE FR GB IT NL**

(30) Priorité: **27.09.1993 FR 9311750**

(43) Date de publication de la demande:
**29.03.1995 Bulletin 1995/13**

(73) Titulaires:
- **SGS-THOMSON MICROELECTRONICS S.A.**
  **94250 Gentilly (FR)**
- **NOKIA TECHNOLOGY GmbH**
  **75175 Pforzheim (DE)**

(72) Inventeur: **Danger, Jean-Luc**
**F-75013 Paris (FR)**

(74) Mandataire: **de Beaumont, Michel**
**1bis, rue Champollion**
**38000 Grenoble (FR)**

(56) Documents cités:
**EP-A- 0 158 980**     **EP-A- 0 181 047**
**EP-A- 0 445 574**     **EP-A- 0 553 744**
**WO-A-93/16529**

## Description

La présente invention concerne une ligne à retard numérique utilisable notamment pour la réalisation d'un oscillateur à fréquence commandée (VCO) faisant partie d'un système de boucle à verrouillage de phase (PLL).

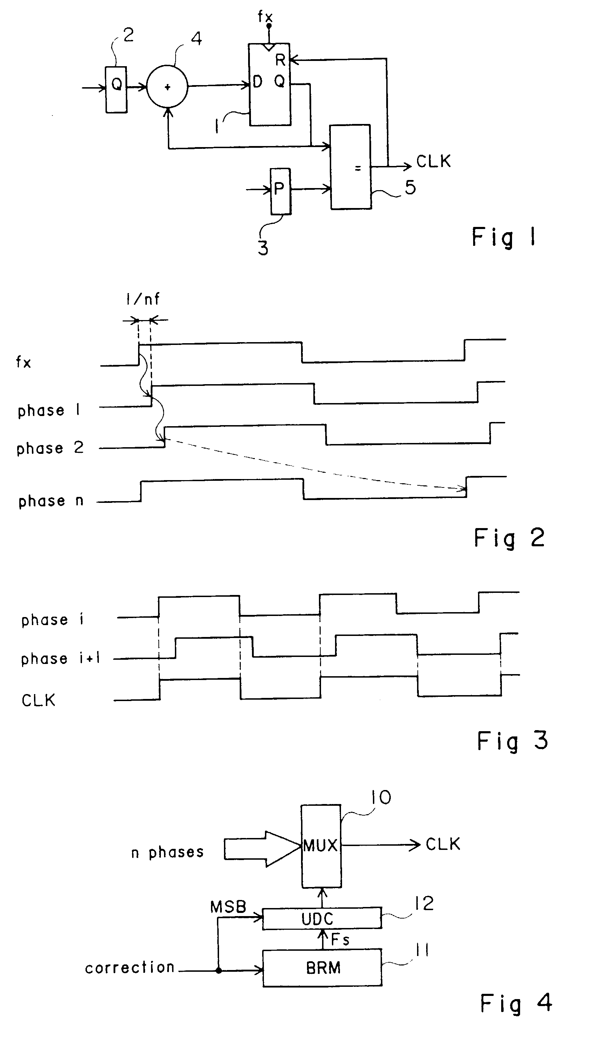

La figure 1 représente un schéma classique de réalisation d'un oscillateur commandé dans une réalisation numérique. Cet oscillateur est piloté par une fréquence fx fournie par un cristal, par exemple une fréquence de 270 MHz. Cette fréquence fx est envoyée à l'entrée d'horloge d'un registre 1. Des registres ou mémoires 2 et 3 contiennent des valeurs programmables Q et P qui sont respectivement ajustées par des signaux de commande de l'oscillateur contrôlé. Le contenu du registre 2 est transféré par l'intermédiaire d'un additionneur 4 à l'entrée D du registre 1 au rythme de l'horloge. La sortie Q du registre 1 est envoyée, d'une part, à une première entrée d'un comparateur numérique 5, d'autre part, à une deuxième entrée de l'additionneur 4. La deuxième entrée du comparateur 5 reçoit la sortie du registre P et la sortie du comparateur fournit le signal CLK recherché et est appliquée comme entrée de remise à zéro au registre 1. L'ensemble du registre 1 et de l'additionneur 4 constitue un accumulateur qui est incrémenté de la valeur Q à chaque impulsion de l'horloge fx. Ainsi, quand la multiplication du nombre Q a atteint la valeur P, le comparateur fournit une impulsion de signal CLK. Ce signal a donc $F_{CLK}=(Q/P)fx$. Bien entendu, ceci suppose que P soit supérieur à Q et même à 2Q. Toutefois, en fait, ce circuit ne fournit pas la fréquence fx multipliée par Q/P mais par la valeur entière majorée de Q/P. En d'autres termes, il y a une erreur de période (un "jitter" ou gigue) de l'ordre de grandeur de la période de la fréquence fx.

Pour augmenter la précision de l'oscillateur et réduire la gigue, il conviendrait donc, ou bien, d'accroître la fréquence fx, ou bien, de lisser la fréquence FCLK en sortie de l'oscillateur. Dans les deux cas, cela implique de rajouter une boucle à verrouillage de phase (PLL) analogique pour multiplier la fréquence du cristal ou pour filtrer la gigue de l'oscillateur. L'utilisation d'une telle boucle analogique est contraire à l'objectif recherché de réalisation d'un oscillateur à fréquence commandée (VCO) entièrement numérique.

Pour résoudre ce problème, on a déjà proposé (voir par exemple IEEE Journal of Solid-State Circuits, Vol. 25, N° 6, Décembre 1990, pages 1385 à 1394) de fournir, comme l'indique la figure 2, à partir d'un signal à la fréquence fx d'un cristal une pluralité de signaux déphasés du n-ième de la période correspondante, respectivement des signaux de phase 1, de phase 2... et de phase n. Alors, comme le représente la figure 3, si l'on utilise le signal de phase i pour fournir une période du signal CLK, on pourra utiliser le signal de phase i+1, ou un autre, pour former la période suivante. En ce cas, la précision ou gigue correspond à la période du signal d'entrée divisée par le nombre de phases.

On pourra par exemple comme le représente la figure 4 introduire les n phases sur n entrées d'un multiplexeur 10 utilisé pour générer le signal CLK. Ce multiplexeur est balayé à une fréquence variable Fs pour fournir le décalage de fréquence. La fréquence Fs est directement proportionnelle au facteur de correction en provenance d'un étage de filtre faisant normalement partie d'une boucle d'un PLL. Un multiplieur de cadence de bits, BRM, 11 est destiné à transférer le mot de correction en un signal de balayage. La sortie du multiplieur 11 est envoyée à un compteur/décompteur (UDC) 12 dont le comptage ou le décomptage est déterminé par le bit le plus significatif (MSB) qui est le bit de signe de la valeur de correction du filtre.

Dans un système de ce genre, l'un des problèmes réside dans la réalisation de n signaux déphasés avec précision à partir du signal fx. Jusqu'à présent, et comme cela est indiqué dans l'article susmentionné, ces n signaux déphasés sont fournis par un compteur en anneau. Toutefois, la fréquence de ce compteur en anneau doit être contrôlée pour être indépendante du processus de fabrication, de la température et de la variation des paramètres de tension. Ce contrôle nécessite à nouveau le recours à des techniques analogiques.

Ainsi, un objet de la présente invention est de prévoir une réalisation ayant recours uniquement à des techniques numériques pour obtenir n signaux déphasés à partir d'un signal d'entrée. En d'autres termes, la présente invention vise à réaliser une ligne à retard numérique programmable permettant de fournir n signaux retardés de 1/n fois la période par rapport à un signal d'entrée de fréquence déterminée.

Pour atteindre cet objet, la présente invention prévoit une ligne à retard numérique fournissant à partir d'un signal périodique d'entrée n signaux de même période mutuellement déphasés du n-ième de la période du signal d'entrée, comprenant :

n cellules de retard identiques ;
des moyens pour comparer la phase de la sortie de la nième cellule à celle du signal d'entrée ;
caractérisée en ce qu'elle comprend :
m éléments de retard identiques en série dans chaque cellule, chaque sortie d'un élément de retard étant reliée à une entrée d'un multiplexeur ; et
des moyens pour décaler d'une unité la sortie d'un et d'un seul multiplexeur à la suite de chaque comparaison.

Selon un mode de réalisation de la présente invention, chaque multiplexeur est constitué de m-1 multiplexeurs à deux entrées, le multiplexeur de rang le plus élevé recevant les sorties des deux dernières cellules, et les multiplexeurs de rang inférieur recevant la sortie du multiplexeur de rang immédiatement précédent et la sortie d'une cellule de rang inférieur à celle traitée par le multiplexeur de rang supérieur.

Selon un mode de réalisation de la présente invention, chaque élément de retard est constitué d'une porte NON ET dont une entrée reçoit le signal à retarder et l'autre entrée reçoit un signal de validation.

Selon un mode de réalisation de la présente invention, le signal de validation est utilisé comme signal de test

Selon un mode de réalisation de la présente invention, le signal de validation est utilisé couine signal d'inhibition pour les éléments de retard non utilisés d'une cellule.

Ces objets, caractéristiques et avantages ainsi que d'autres de la présente invention seront exposés en détail dans la description suivante de modes de réalisation particuliers faite à titre non limitatif en relation avec les figures jointes parmi lesquelles :

les figures 1 à 4 décrites précédemment sont destinées à exposer l'état de la technique et le problème posé ;

la figure 5 représente une ligne à retard numérique selon la présente invention ;

la figure 6 représente une cellule d'une ligne à retard numérique selon la présente invention ;

la figure 7 est un chronogramme destiné à illustrer certaines caractéristiques de la ligne à retard numérique selon la présente invention ;

la figure 8 illustre un mode de commande d'une ligne à retard numérique selon la présente invention ;

la figure 9 représente un mode de réalisation d'une cellule d'une ligne à retard selon la présente invention ;

la figure 10 représente des signaux susceptibles de se produire lors de la commande d'un multiplexeur ; et

la figure 11 représente un circuit de temporisation associé à la commande d'un multiplexeur.

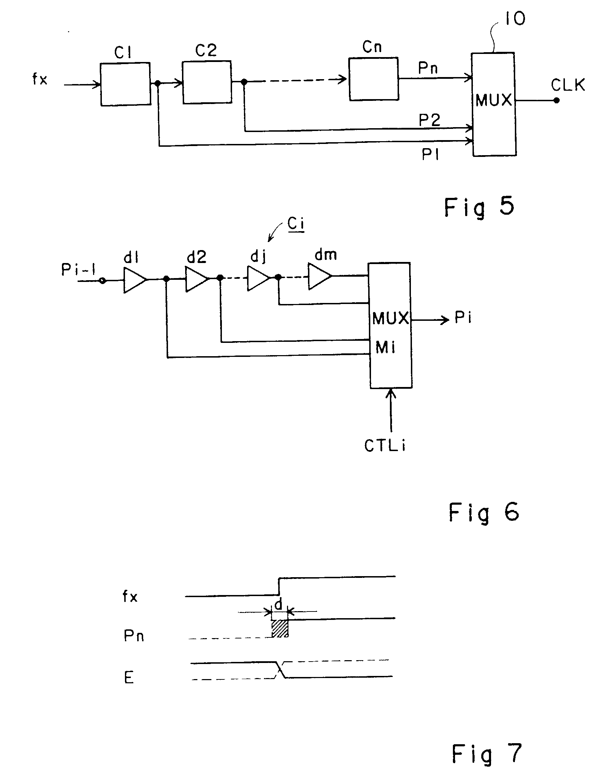

Comme le représente la figure 5, la présente invention propose d'utiliser une ligne à retard à n cellules $C_1$, $C_2$... $C_i$... $C_n$ fournissant chacune un signal retardé par rapport à un signal d'entrée fx, c'est-à-dire des signaux $P_1$, $P_2$... $P_i$... $P_n$, aux entrées d'un multiplexeur 10.

On soulignera qu'il s'agit là d'une ligne à retard en boucle ouverte et non pas d'un circuit bouclé en anneau.

La figure 6 représente un mode de réalisation d'une cellule $C_i$ de la ligne à retard de la figure 5. Cette cellule est constituée de m éléments de retard $d_1$, $d_2$... $d_j$... $d_m$. Le premier élément de retard $d_1$ reçoit la sortie $P_{i-1}$ de la cellule précédente et la sortie de chacun des éléments de retard $d_j$ est fournie à une entrée d'un multiplexeur $M_i$ dont la sortie correspond au signal $P_i$ et est envoyée à l'entrée de la cellule suivante (et au multiplexeur 10).

Dans ce mode de réalisation, chacun des éléments de retard $d_j$ présente un même retard de propagation d. Ainsi, en choisissant au moyen du multiplexeur $M_i$ le signal de sortie de l'une des cellules $d_1$ à $d_m$, le retard entre les signaux $P_{i-1}$ et $P_i$ est égal à j*d et peut varier entre d et m*d.

Chaque multiplexeur $M_i$ reçoit un signal de commande $CTL_i$ dont le mode de fourniture sera exposé ci-après.

Les multiplexeurs $M_i$ sont reliés à un pointeur qui adresse chacun de ces multiplexeurs séquentiellement, dans l'ordre du premier au dernier ou, comme on le verra ci-après, dans tout autre ordre choisi mais de manière que tous les multiplexeurs aient été pointés avant qu'un multiplexeur soit pointé une deuxième fois. Chaque fois qu'un multiplexeur donné est pointé, le numéro d'ordre de son entrée est incrémenté ou décrémenté en fonction du résultat d'une comparaison entre la sortie $P_n$ de la nième cellule et le signal fx.

Une fois que la ligne à retard selon la présente invention a été préréglée au voisinage du réglage souhaité, son réglage est peu susceptible de se dérégler, si ce n'est par suite de variations de température ou de fluctuations de la fréquence fx.

Ainsi, comme le représente la figure 7, quand le système est sensiblement calé à son point de fonctionnement normal, l'écart entre les fronts montants du signal fx et du signal $P_n$ est au maximum égal à la valeur ±d. On détecte donc une erreur E positive (1) ou négative (0).

A la suite de chaque détection de l'erreur E, l'un des multiplexeurs est incrémenté ou décrémenté. Lors de la détection suivante, l'erreur s'est normalement inversée et le multiplexeur pointé alors devra inversement être décrémenté ou incrémenté.

Bien entendu, comme cela a été indiqué précédemment, le pointage est réalisé de sorte qu'à un instant donné, il n'y ait jamais un écart supérieur à d entre les retards apportés par deux cellules distinctes. On dispose ainsi d'un système à ajustement permanent. On notera que le taux de réalisation de comparaisons entre fx et $P_n$ n'est pas nécessairement très élevé et peut être de plusieurs périodes d'horloge puisque les paramètres de synchronisation changent lentement au cours du temps dans un fonctionnement normal du système.

Lors de l'initialisation du fonctionnement de la ligne à retard selon l'invention, chacune des cellules $C_1$ à $C_n$ est automatiquement placée à son retard minimum et, à partir de là, le retard de chacune des cellules est incrémenté jusqu'à ce que l'on trouve une erreur qui alterne entre une incrémentation et une décrémentation. On arrive alors au fonctionnement à l'état stable décrit en relation avec la figure 7.

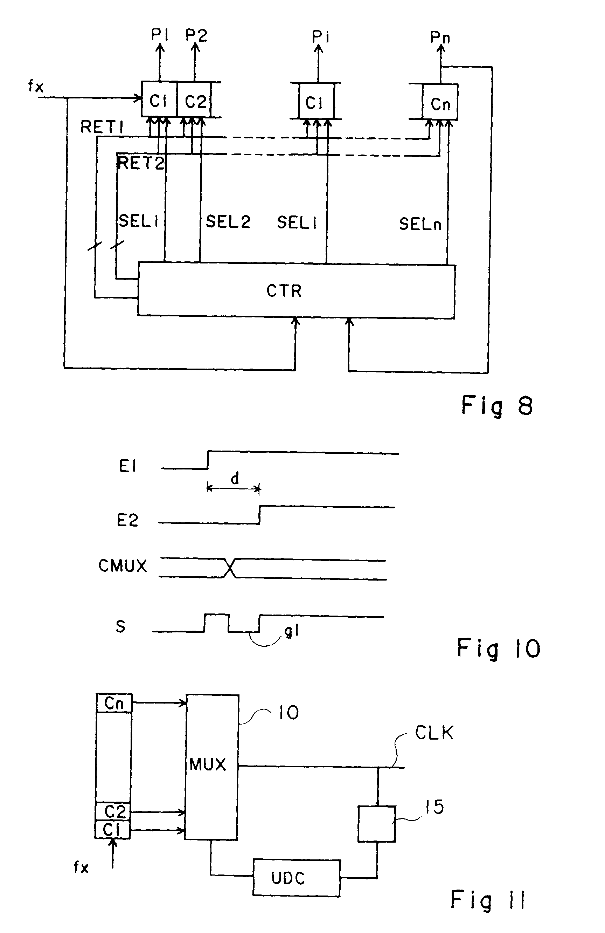

La figure 8 illustre un mode de réalisation de la commande de l'ensemble des cellules à retard $C_1$ à $C_n$ selon la présente invention. Chacune de ces cellules fournit un signal respectif $P_1$, $P_2$...$P_n$ vers le multiplexeur 10. Un circuit de contrôle CTR est destiné à la commande de chacune des cellules et plus exactement de décodeurs associés à chacun des multiplexeurs $M_i$ de ces cellules. Comme cela a été indiqué précédemment, ce circuit de contrôle CTR reçoit le signal d'entrée fx et le signal de sortie Pn et détermine que le retard d'une cellule à un instant donné doit être incrémenté ou décrémenté en fonction du signe de la différence E entre les signaux fx et Pn. Dans le mode de réalisation illustré, le circuit de contrôle fournit des sorties SEL1, SEL2... SELn de sélection de chacune des cellules C1, C2... On et des valeurs RET1 et RET2 qui diffèrent entre elles d'une unité et qui fixent le retard de chacune des cellules, c'est-à-dire le numéro de l'entrée du multiplexeur Mi qui doit être connecté à sa sortie Pi. Selon la valeur SELi appliquée à une cellule Ci, celle-ci sera commandée par le signal RET1 ou par le signal RET2. Ainsi, les retards apportés par chacune des cellules diffèrent au plus d'un retard élémentaire d. Le circuit de contrôle CTR comprend des moyens logiques pour que, quand tous les signaux SEL1 à SELn ont la même valeur, c'est-à-dire que toutes les cellules présentent le même retard, les signaux RET1 et RET2 changent d'état.

Ainsi, si l'on part d'un état initial où toutes les cellules sont placées à leur retard minimal, les valeurs initiales du couple RET1, RET2 seront (RET1,RET2)=(1,2). Ensuite, quand tous les SELi passent à 1, le couple (RET1,RET2) passe à (3,2) puis quand tous les SELi seront à zéro à (3,4), et ainsi de suite jusqu'à (m-1,m) si l'on est amené à arriver au retard maximal possible. On notera que, quand les signaux SELi sont amenés à passer de 0 à 1 ou de 1 à 0, l'évolution des changements doit se faire d'une manière équilibrée de façon que la cellule Ci génère un signal Pi ayant une phase la plus proche possible de $(2 + i/n)PI$. Pour cela, il est déconseillé de faire une évolution séquentielle des retards des cellules C1 à Cn. Une meilleure évolution possible consiste à sélectionner séquentiellement les signaux suivants (dans le cas où n est une puissance de 2) : SEL1, SELn/2, SELn/4, SEL3n/4, SELn/8, SEL5n/8, SEL3n/8, SEL7n/8...

Plage de fréquence et fluctuation de fréquence (gigue)

La gigue intrinsèque à la ligne à retard est d car nous avons vu que Pn subissait une fluctuation de +d par rapport à fx. Les technologies CMOS courantes existantes permettent de fournir des éléments de retard d dont l'ordre de grandeur est normalement de 0,5 à 1 nanoseconde, ce qui implique une gigue acceptable pour une large gamme d'applications.

La plage de fréquence de la ligne à retard dépend du nombre n de cellules Ci, du nombre m d'éléments de retard dj par cellule et de la technologie utilisée. Si l'on considère que dans un processus MOS classique dans lequel on recherche un retard élémentaire d, ce retard peut en fait varier entre d/2 (meilleur cas) et 2d (pire cas). Le retard total de la ligne à retard peut donc varier entre n*d/2 et m*n*d/2 dans le meilleur cas et n*2d et m*n*2d dans le pire cas. Pour que le générateur de phase puisse se verrouiller dans tous les cas, le retard total de la ligne à retard donc la période d'utilisation 1/fx doit être compris entre 2n*d et n*m*d/2, d'où

$$fmin = 2/m*n*d \text{ et } fmax = 1/n*2d$$

A titre d'exemple, dans un cas où m=8, n=16, d=0,8 ns, on obtient fmin=19,5 MHz, fmax=39 MHz, la gigue étant égale à d=0,8 ns.

Si le générateur de phases est utilisé dans une architecture de VCO numérique, la gigue propre au VCO est 1/n fois la fréquence du cristal, soit 1/nfx. Etant donné qu'il n'y a a priori aucune relation temporelle entre la correction du générateur de phases (dont la gigue est d), et la gigue intrinsèque de la boucle PLL, la gigue totale, J, est :

$$J = [(1/nfx)^2 + d^2]^{\frac{1}{2}},$$

ce qui donne, dans le cadre de l'exemple ci-dessus

$$2,12 < J < 2,62 \text{ ns.}$$

Exemple de réalisation

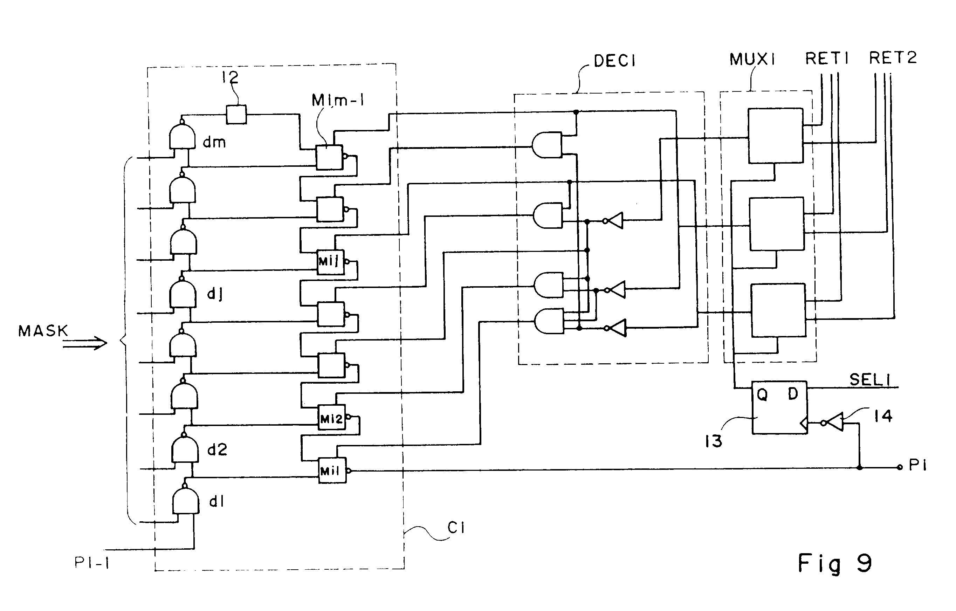

La figure 9 représente uniquement à titre d'exemple un mode de réalisation d'une cellule telle que celle de la figure 6, associée à un circuit de commande du type de celui de la figure 8. Chacun des éléments de retard dj est constitué d'une porte NON ET et l'on a représenté le cas particulier où il est prévu un nombre m=8 d'éléments de retard. La première entrée de chacune des portes NON ET est reliée à la sortie de la porte NON ET de rang inférieur, la porte d1 recevant le signal Pi-1. La sortie de chacune des portes NON ET est également envoyée à la première entrée d'un multiplexeur Mij à deux voies dont l'autre entrée reçoit la sortie du multiplexeur de rang supérieur, à l'exception du dernier multiplexeur $M_{im-1}$ qui reçoit la sortie de la porte NON ET dm. En fait, quand on considère le retard de chacune des éléments de retard, il faut tenir compte du passage dans le multiplexeur correspondant. Ainsi, derrière la porte NON ET dm qui comprend un passage de moins dans un multiplexeur que les autres éléments de retard, on rajoute un élément de retard 12.

Chacun des multiplexeurs $M_{i1}$ à $M_{im-1}$ reçoit des signaux de commande en provenance d'un circuit décodeur DECi commandé par un ensemble de multiplexeurs MUXi qui reçoivent des signaux RET1, RET2 et SELi en provenance d'un circuit de contrôle tel que le circuit CTR de la figure 8. Un exemple particulier de réalisation des blocs MUXi et DECi est illustré dans la figure en utilisant des symboles classiques représentant des multiplexeurs, des inverseurs et des portes ET et ne sera pas décrit en détail car de nombreuses variantes sont possibles. L'objet de ces circuits est de fournir des signaux de commande aux multiplexeurs Mij de façon à mettre dans un premier état des multiplexeurs $M_{i1}$ à $M_{ik}$ et dans un deuxième état les multiplexeurs $M_{ik}$ à $M_{im-1}$ en relation avec la valeur du signal RET1 ou RET2.

Chacune des portes NON ET d1 à dm reçoit sur sa deuxième entrée un signal correspondant à un conducteur d'un bus MASK. Les signaux de ce bus MASK peuvent être utilisés dans des buts de test pour tester le fonctionnement du circuit en imposant des signaux choisis à la sortie de chacune des portes NON ET. Ce bus MASK sera aussi de préférence utilisé lors du fonctionnement de la cellule Ci pour inhiber les portes NON ET non utilisées de cette cellule. Ceci permet de minimiser la consommation de puissance.

Par ailleurs, l'utilisation de portes NON ET constituant des cellules inverseuses en série permet d'équilibrer les retards sur front montant et front descendant. Le rapport cyclique du signal Pi sera ainsi peu affecté par son passage à travers la cellule Ci. En outre, le changement de numéro d'ordre du multiplexeur Mi constitué de multiplexeurs élémentaires à deux entrées $M_{il}$ à $M_{im\_1}$ se fait sans aléa de commutation du fait que le passage du multiplexeur $M_{ij}$ au multiplexeur $M_{ij+1}$ ne nécessite qu'une seule transition sur le signal de commande de ce multiplexeur.

Parasites de commutation

On notera que le dispositif selon l'invention fait usage de nombreux circuits de multiplexage. L'un des problèmes résultant de l'utilisation d'un multiplexeur est lié au moment de commutation qui doit être tel qu'aucun parasite n'apparaisse en sortie.

Comme le montre la figure 10, pour un multiplexeur ayant deux entrées E1 et E2, dont les fronts montants sont par exemple espacés de la valeur d, si l'on applique un signal de commande CMUX du multiplexeur qui tend à faire commuter les sorties entre les fronts montants de E1 et E2, il apparaîtra sur le signal de sortie S une impulsion négative parasite GL, couramment désignée dans la technique par le terme "glitch". Dans le cas du multiplexeur Mi décrit précédement, le retard entre deux entrées est d. Si la commande du multiplexeur est synchronisée sur l'entrée 1 et si elle est retardée d'au moins d par rapport à cette entrée 1, aucun parasite n'apparaîtra. C'est pourquoi, on utilise comme le représente la figure 9 une bascule 13 de type D de synchronisation du signal SELi. Le retard de cette bascule, du multiplexeur MUXi et du décodeur DECi est choisi supérieur à d. Du fait que les signaux issus du bloc de contrôle (RET1, RET2, SELi) sont synchronisés sur fx, la bascule de synchronisation de SELi peut avoir des états métastables. Pour éviter cela, on utilise le front montant de Pi pour les cellules ayant une phase importante jusqu'à Cn et le front descendant de Pi pour les cellules ayant une phase faible (à partir de C0). Ainsi, pour ces dernières cellules, il est prévu d'insérer un inverseur 14 entre la sortie du signal Pi et l'entrée de synchronisation de la bascule 13.

Dans le cas de l'application de la présente invention à la réalisation d'un VCO numérique, le problème des "glitch" liés au multiplexage se présente toujours. Ainsi, la figure 11 illustre un mode de synchronisation du multiplexeur 10. La commande du multiplexeur 10 par un compteur/décompteur UDC est synchronisée sur la sortie CLK de ce multiplexeur retardée d'un retard équivalent à celui d'une cellule Ci imposé par un circuit de retard 15.

La ligne à retard numérique équilibrée selon la présente invention est susceptible de nombreuses applications qui apparaitront à l'homme de l'art. Elle peut, comme cela a été indiqué précédemment être utilisée pour la réalisation d'un oscillateur à fréquence commandée (VCO) d'un PLL, par exemple d'un PLL à application vidéo dans lequel la fréquence fx est de 32 mégahertz et pour lequel la gigue sera inférieure à 5 ns. Elle pourrait également être utilisée pour oompenser le retard de signaux provoqué par les problèmes de ligne inhérents aux circuits imprimés. Elle pourrait aussi servir à déterminer et donc à récupérer la phase de certains signaux asynchrones ou désynchronisés, dans le domaine des télécommunications.

**Revendications**

1. Ligne à retard numérique fournissant à partir d'un signal périodique d'entrée (fx) n signaux de même période (P1... Pi... Pn) mutuellement déphasés du n-ième de la période du signal d'entrée, comprenant :

    n cellules de retard identiques (C1 à Cn) ;
    des moyens pour comparer la phase (Pn) de la sortie de la nième cellule à celle du signal d'entrée ;
    caractérisée en ce qu'elle comprend :
    m éléments de retard identiques ($d_1$... $d_j$... $d_m$) en série dans chaque cellule, chaque sortie d'un élément de retard étant reliée à une entrée d'un multiplexeur (Mi) ; et
    des moyens pour décaler d'une unité la sortie d'un et d'un seul multiplexeur à la suite de chaque comparaison.

2. Ligne à retard selon la revendication 1, caractérisée en ce que chaque multiplexeur (Mi) est constitué de m-1 multiplexeurs à deux entrées, le multiplexeur de rang le plus élevé ($M_{im-1}$) recevant les sorties des deux dernières cellules, et les multiplexeurs de rang inférieur recevant la sortie du multiplexeur de rang immédiatement précédent et la sortie d'une cellule de rang inférieur à celle traitée par le multiplexeur de rang supérieur.

3. Ligne à retard selon la revendication 1, caractérisée en ce que chaque élément de retard (di) est constitué d'une porte NON ET dont une entrée reçoit le signal à retarder et l'autre entrée reçoit un signal de validation (MASK).

4. Ligne à retard selon la revendication 3, caractérisée en ce que le signal de validation (MASK) est utilisé comme signal de test.

5. Ligne à retard selon la revendication 3, caractérisée en ce que le signal de validation (MASK) est utilisé comme signal d'inhibition pour les éléments de retard non utilisés d'une cellule.

6. Ligne à retard selon la revendication 2, caractérisée en ce que les signaux de commande de chacun des multiplexeurs à deux entrées sont retardés de la durée de retard d'un élément de retard par rapport à la phase du signal d'entrée traitée par la cellule concernée.

7. Application d'une ligne à retard selon l'une quelconque des revendications 1 à 6 à la constitution d'un oscillateur à fréquence commandée, chacune des sorties de la ligne à retard étant couplée à un multiplexeur (10) qui sélectionne l'une de ses sorties en fonction de signaux fournis par une boucle à verrouillage de phase numérique.

**Patentansprüche**

1. Digitale Verzögerungsleitung, welche ausgehend von einem periodischen Eingangssignal (fx) n Signale derselben Periode (P1 ... Pi ... Pn) erzeugt, die gegeneinander jeweils um den n-ten Teil der Periode des Eingangssignals in der Phase versetzt sind, die Verzögerungsleitung umfassend:

- n gleichartige Verzögerungszellen (C1 bis Cn);

- Mittel zum Vergleichen der Phase (Pn) der Ausgangsgröße der n-ten Zelle mit der Phase des Eingangssignals;

dadurch gekennzeichnet, daß die Verzögerungsleitung umfaßt:

- m gleichartige Verzögerungselemente ($d_1$ ... $d_j$ ... ... $d_m$) in Reihe in jeder Zelle, wobei jeweils der Ausgang eines Verzögerungselements mit einem Eingang eines Multiplexers (Mi) verbunden ist; sowie

- Mittel, um nach jedem Vergleich jeweils den Ausgang eines, und nur eines, Multiplexers um eine Einheit zu verschieben bzw. zu versetzen.

2. Verzögerungsleitung nach Anspruch 1, dadurch gekennzeichnet, daß jeweils jeder Multiplexer (Mi) aus m - 1 Multiplexern mit zwei Eingängen zusammengesetzt ist, wobei der Multiplexer mit dem höchsten Rang ($M_{im-1}$) die Ausgangsgrößen der beiden letzten Zellen zugeführt erhält und die Multiplexer von niedrigerem Rang die Ausgangsgröße des Multiplexers mit dem unmittelbar vorhergehenden Rang und die Ausgangsgröße einer Zelle zugeführt erhalten, deren Rang niedriger als der Rang der von dem Multiplexer höheren Rangs verarbeiteten Zelle ist.

3. Verzögerungsleitung nach Anspruch 1, dadurch gekennzeichnet, daß jeweils jedes Verzögerungselement (di) aus einem NAND-Gatter besteht, dessen einem Eingang das zu verzögernde Signal und dessen anderem Eingang ein Validierungs- bzw. Freigabesignal (MASK) zugeführt wird.

4. Verzögerungsleitung nach Anspruch 3, dadurch gekennzeichnet, daß das Validierungssignal (MASK) als Testsignal verwendet wird.

5. Verzögerungsleitung nach Anspruch 3, dadurch gekennzeichnet, daß das Validierungssignal (MASK) als Inhibier- bzw. Sperrsignal für die nicht verwendeten Verzögerungselemente einer Zelle verwendet wird.

6. Verzögerungsleitung nach Anspruch 2, dadurch gekennzeichnet, daß die Steuersignale jedes der Multiplexer mit zwei Eingängen um die Verzögerungsdauer eines Verzögerungselements bezüglich der Phase des von der betreffenden Zelle verarbeiteten Eingangssignals verzögert sind.

7. Anwendung einer Verzögerungsleitung gemäß einem der Ansprüche 1 bis 6 zur Schaffung eines Oszillators mit gesteuerter Frequenz, wobei jeweils jeder der Ausgänge der Verzögerungsleitung mit einem Multiplexer (10) verbunden ist, welcher einen seiner Ausgänge in Abhängigkeit von Signalen auswählt, die von einer digitalen Schleife mit Phasenverriegelung geliefert werden.

**Claims**

1. A digital delay line supplying from a periodic input signal (fx) n signals with the same period (P1... Pi... Pn) mutually phase-shifted by one n-th of the input signal period, including:

    n identical delay cells (C1-Cn);
    means for comparing the output phase (Pn) of the n-th cell with the input signal phase;

characterized in that it comprises:

m identical delay elements ($d_1$... $d_j$... $d_m$) in series in each cell, each output of a delay element being connected to an input of a multiplexer (Mi); and

means for shifting of one unit the output of one and only one multiplexer further to each comparison.

2. The delay line of claim 1, characterized in that each multiplexer (Mi) is formed by m-1 two-input multiplexers, the multiplexer with the highest rank ($M_{im-1}$) receiving the outputs of the last two cells, and the multiplexers of lower rank receiving the output of the multiplexer having the immediately former rank and the output of a cell having a rank lower than the cell processed by the multiplexer of higher rank.

3. The delay line of claim 1, characterized in that each delay element (di) is formed by an NAND gate having an input that receives the signal to be delayed and the other input that receives an enabling signal (MASK).

4. The delay line of claim 3, characterized in that the enabling signal (MASK) is used as a test signal.

5. The delay line of claim 3, characterized in that the enabling signal (MASK) is used as an inhibition signal for the not-used delay elements of a cell.

6. The delay line of claim 2, characterized in that the control signals of each two-input multiplexer are delayed by the delay period of a delay element with respect to the input signal phase processed by the corresponding cell.

7. Application of a delay line according to any of claims 1 to 6 for the fabrication of a voltage controlled oscillator, each of the outputs of the delay line being coupled to a multiplexer (10) that selects one of its outputs as a function of signals provided by a digital phase-locked loop.

Fig 1

Fig 2

Fig 3

Fig 4

Fig 5

Fig 6

Fig 7

Fig 8

Fig 10

Fig 11

Fig 9